# FASCICULE DE BREVET EUROPEEN

(11) **EP 4 062 451 B1**
(45) Date de publication et mention de la délivrance du brevet: **16.08.2023**
(21) Numéro de dépôt: 20807051.6
(22) Date de dépôt: 19.11.2020
(51) Int. Cl.: H01L 27/146

(54) **PROCEDE DE FABRICATION D'UN DISPOSITIF DE DETECTION PRESENTANT UNE PROTECTION AMELIOREE DU GETTER**
VERFAHREN ZUM HERSTELLEN EINER DETEKTIONSVORRICHTUNG, DIE VERBESSERTEN GETTERSCHUTZ AUFWEIST
METHOD FOR MANUFACTURING A DETECTION DEVICE HAVING IMPROVED GETTER PROTECTION

(30) Priorité: 22.11.2019 FR 1913138
(43) Date de publication de la demande: 28.09.2022
(73) Titulaire: Commissariat à l'Energie Atomique et aux Energies Alternatives, 75015 Paris (FR)
(72) Inventeur: DUMONT, Geoffroy, 38054 GRENOBLE cedex 09 (FR); CARLE, Laurent, 38054 GRENOBLE cedex 09 (FR); YON, Jean-Jacques, 38054 GRENOBLE cedex 09 (FR)
(74) Mandataire: Brevalex
(86) Numéro de dépôt international: PCT/EP2020/082703
(87) Numéro de publication internationale: WO 2021/099477

(56) Documents cités:
- US-A1- 2016 023 888
- US-A1- 2019 051 787

## Description

### DOMAINE TECHNIQUE

Le domaine de l'invention est celui des dispositifs de détection de rayonnement électromagnétique, en particulier infrarouge ou térahertz, comportant au moins un détecteur thermique encapsulé dans une cavité hermétique, dans laquelle est également situé un matériau getter. L'invention s'applique notamment au domaine de l'imagerie infrarouge et de la thermographie. Le document US 2016/023888 A1 est un art antérieure pertinent.

### ÉTAT DE LA TECHNIQUE ANTÉRIEURE

Un dispositif de détection de rayonnement électromagnétique, par exemple infrarouge ou térahertz, peut comprendre une matrice de détecteurs thermiques comportant chacun une portion absorbante apte à absorber le rayonnement électromagnétique à détecter.

Dans le but d'assurer l'isolation thermique des détecteurs thermiques, les portions absorbantes se présentent habituellement sous la forme de membranes suspendues au-dessus du substrat par des piliers d'ancrage, et isolées thermiquement de celui-ci par des bras de maintien et d'isolation thermique. Ces piliers d'ancrage et bras de maintien présentent également une fonction électrique en reliant électriquement les membranes suspendues à un circuit de lecture généralement disposé dans le substrat.

Le circuit de lecture se présente habituellement sous la forme d'un circuit CMOS. Il permet l'application d'un signal de commande aux détecteurs thermiques ainsi que la lecture de signaux de détection générés par ces derniers en réponse à l'absorption du rayonnement électromagnétique à détecter. Le circuit de lecture comporte différents niveaux d'interconnexion électrique formés de lignes métalliques séparées les unes des autres par des couches diélectriques dites inter-métal. Au moins un plot de connexion électrique du circuit de lecture est disposé sur le substrat de telle manière qu'il puisse être contacté depuis l'extérieur du dispositif de détection.

Le document EP3239670A1 décrit un procédé de fabrication d'un dispositif de détection dont les détecteurs thermiques sont disposés dans une cavité hermétique. Le procédé utilise des couches sacrificielles minérales pour réaliser les détecteurs thermiques ainsi que la structure d'encapsulation définissant la cavité, lesquelles sont ensuite supprimées par une gravure chimique humide. La cavité est délimitée par une couche mince d'encapsulation qui s'étend au-dessus et autour du ou des détecteurs thermiques. Elle est réalisée par dépôt sur la face supérieure d'une couche sacrificielle minérale supérieure, ainsi que dans des tranchées qui s'étendent au travers des couches sacrificielles minérales. Ainsi, la couche mince d'encapsulation est formée d'une paroi supérieure qui repose sur la couche sacrificielle minérale supérieure, ainsi que d'une paroi périphérique qui repose sur le substrat et entoure le ou les détecteurs thermiques dans un plan parallèle au substrat. Cette configuration permet notamment de réduire l'encombrement sur le substrat de la structure d'encapsulation.

D'autre part, le procédé de fabrication décrit dans ce document prévoit de réaliser une portion d'un matériau getter, par exemple en titane, dans la cavité hermétique. Cette portion getter est alors située sous chaque membrane absorbante, et est protégée de la gravure chimique humide par une couche mince sacrificielle carbonée, par exemple réalisée en carbone amorphe, laquelle est ensuite supprimée par une gravure chimique sèche spécifique.

Cependant, il existe un besoin de renforcer la protection du matériau getter lors de la suppression des couches sacrificielles minérales par la gravure chimique humide, tout en maintenant un encombrement réduit sur le substrat de la structure d'encapsulation.

### EXPOSÉ DE L'INVENTION

L'invention a pour objectif de remédier au moins en partie aux inconvénients de l'art antérieur. Pour cela, l'objet de l'invention est un procédé de fabrication d'un dispositif de détection d'un rayonnement électromagnétique comportant les étapes suivantes :
- réalisation d'au moins un détecteur thermique destiné à détecter le rayonnement électromagnétique, reposant sur un substrat, et recouvert par une couche sacrificielle minérale en un matériau minéral apte à être supprimé par une première gravure chimique ;
- réalisation d'au moins un plot dit getter :
   o s'étendant partiellement sur la couche sacrificielle minérale, et étant disposé à distance du détecteur thermique dans un plan parallèle au substrat,
   o formé d'un empilement de portions de couches minces planes parallèles entre elles, dont une portion de protection en carbone amorphe apte à être supprimé par une deuxième gravure chimique et reposant au contact de la couche sacrificielle minérale, et au moins une portion getter en un matériau getter reposant au contact de la portion de protection ;
- réalisation d'une couche mince d'encapsulation s'étendant au-dessus du détecteur thermique, comportant une partie supérieure reposant sur la couche sacrificielle minérale et recouvrant une face supérieure et des flancs du plot getter ;
- réalisation d'au moins un premier évent au travers de la couche mince d'encapsulation, situé à distance du plot getter dans un plan parallèle au substrat et débouchant sur la couche sacrificielle minérale ;
- suppression de la couche sacrificielle minérale par la première gravure chimique, libérant ainsi une surface de la portion de protection ;
- suppression de la portion de protection par une deuxième gravure chimique, libérant ainsi une surface de la portion getter ;
- dépôt d'une couche mince de scellement sur la couche mince d'encapsulation, de manière à obturer au moins le premier évent.

Par suppression de la couche sacrificielle minérale par la première gravure chimique, on entend une suppression au moins partielle de cette couche, de manière à libérer une surface de la portion de protection.

Certains aspects préférés mais non limitatifs de ce procédé de fabrication sont les suivants.

Le procédé de fabrication peut comporter une étape de réalisation d'au moins un détecteur de compensation destiné à ne pas recevoir le rayonnement électromagnétique à détecter, le plot getter étant disposé en regard du détecteur de compensation.

Une pluralité de détecteurs thermiques et de détecteurs de compensation peut être réalisée, au moins un plot getter étant disposé en regard des détecteurs de compensation.

Le détecteur thermique et le détecteur de compensation peuvent comporter chacun une membrane suspendue au-dessus du substrat par des piliers d'ancrage, la couche mince d'encapsulation comportant au moins un pilier de soutien réalisé d'un seul tenant avec la partie supérieure, et s'étendant à partir de la partie supérieure jusqu'à reposer sur un pilier d'ancrage.

Le procédé de fabrication peut comporter une étape de réalisation d'une couche en un matériau électriquement isolant disposée entre et au contact du pilier de soutien et du pilier d'ancrage.

A la suite de l'étape de réalisation d'une couche mince d'encapsulation, la couche mince d'encapsulation peut s'étendre continûment au-dessus et autour du détecteur thermique, et être formée de la partie supérieure et d'une partie périphérique, lesquelles sont alors réalisées d'un seul tenant, la partie périphérique de la couche mince d'encapsulation s'étendant dans une tranchée réalisée au travers de la couche sacrificielle minérale et au contact des flancs de celle-ci, la partie périphérique reposant sur le substrat.

Le plot getter peut comporter plusieurs portions getter superposées suivant un axe perpendiculaire au substrat, chacune étant disposée entre deux portions de protection.

La portion getter peut recouvrir entièrement une face de la portion de protection opposée au substrat.

Lors de l'étape de réalisation du premier évent, au moins un deuxième évent peut être réalisé au travers de la couche mince d'encapsulation de manière à déboucher sur une portion de protection supérieure recouvrant lesdites portions getter, puis, à la suite de l'étape de suppression de la couche sacrificielle minérale, une ouverture peut être réalisée à partir du deuxième évent de manière à déboucher sur une portion de protection inférieure, sur laquelle reposent lesdites portions getter.

Une deuxième couche mince de scellement peut être déposée de manière à obturer le deuxième évent, cette deuxième couche mince de scellement étant distincte de la couche mince de scellement obturant le premier évent.

Le plot getter peut comporter plusieurs portions getter et plusieurs portions de protection superposées suivant un axe perpendiculaire au substrat. Une sur-gravure latérale des portions de protection peut être effectuée de manière sélective vis-à-vis des portions getter.

La couche sacrificielle minérale peut être réalisée en un oxyde de silicium obtenu à partir d'un orthosilicate de tétraéthyle.

Par ailleurs, lors de la réalisation d'au moins un détecteur thermique, celui-ci peut reposer sur une première couche sacrificielle minérale, le détecteur thermique et la première couche sacrificielle minérale étant recouverts par une deuxième couche sacrificielle minérale, les première et deuxième couches sacrificielles minérales étant en un matériau minéral apte à être supprimé par la première gravure chimique. Le premier évent peut être disposé en regard du détecteur thermique ou le cas échéant en regard d'une matrice de détecteurs thermiques. Lors de la première gravure chimique, celle-ci pouvant être une gravure humide en milieu acide, les première et deuxième couches sacrificielles minérales peuvent être supprimées partiellement au travers du premier évent, une portion non gravée des première et deuxième couches sacrificielles minérales formant une paroi périphérique qui entoure le détecteur thermique (ou la matrice de détecteurs thermiques, le cas échéant) dans un plan parallèle au substrat. La partie supérieure de la couche d'encapsulation repose sur et au contact de la paroi périphérique.

A la suite de la première gravure chimique, la paroi périphérique peut présenter un retrait latéral se traduisant par un élargissement vertical de la cavité parallèlement au substrat de lecture, entre le substrat de lecture et la partie supérieure, ce retrait latéral définissant une zone intermédiaire d'une surface du substrat de lecture entourant le détecteur thermique ou le cas échéant une matrice de détecteurs thermiques.

Le procédé peut comporter une étape de réalisation de piliers de renfort de la couche mince d'encapsulation, agencés dans la zone intermédiaire autour du détecteur thermique ou le cas échéant une matrice de détecteurs thermiques, distincts les uns des autres, et s'étendant à partir de la partie supérieure jusqu'à reposer sur le substrat de lecture. Les piliers de renfort peuvent reposer directement sur le substrat, et donc être au contact de celui-ci, ou reposer indirectement sur le substrat, par exemple en venant au contact de piliers d'ancrage.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1I sont des vues schématiques et partielles, en coupe transversale, de différentes étapes d'un procédé de fabrication d'un dispositif de détection selon un premier mode de réalisation ;
les figures 2A à 2D sont des vues schématiques et partielles, en coupe transversale, de différentes étapes d'un procédé de fabrication d'un dispositif de détection selon une variante de réalisation dans laquelle une sur-gravure latérale est effectuée sur certaines des portions de couches formant le plot getter ;
la figure 3 est une vue de dessus d'un dispositif de détection selon un mode de réalisation, illustrant des détecteurs thermiques et des détecteurs de compensation, ainsi qu'un agencement des portions getter ;
les figures 4A à 4C sont des vues schématiques et partielles, en coupe transversale, de différentes étapes d'un procédé de fabrication d'un dispositif de détection selon une autre variante de réalisation dans laquelle une couche de scellement spécifique recouvre le plot getter ;
les figures 5A à 5C sont des vues schématiques et partielles, en coupe transversale, de différentes étapes d'un procédé de fabrication d'un dispositif de détection selon une autre variante de réalisation ;
les figures 6A à 6C sont des vues schématiques et partielles, en coupe transversale, de différentes étapes d'un procédé de fabrication d'un dispositif de détection selon une autre variante de réalisation, dans lequel la structure d'encapsulation comporte une paroi périphérique réalisée en un matériau minéral ;
les figures 7A à 7C sont des vues schématiques et partielles, en coupe transversale, de différentes étapes d'un procédé de fabrication d'un dispositif de détection selon une autre variante de réalisation, dans lequel la structure d'encapsulation comporte une paroi périphérique réalisée en un matériau minéral, et dans lequel le matériau sacrificiel minéral est évacué au travers des premiers et deuxièmes évents.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 1 0% près, et de préférence à 5% près. Par ailleurs, les termes « compris entre ... et ... » et équivalents signifient que les bornes sont incluses, sauf mention contraire.

L'invention porte d'une manière générale sur un procédé de fabrication d'un dispositif de détection de rayonnement électromagnétique adapté à détecter un rayonnement infrarouge ou térahertz. Ce dispositif de détection comporte un ou plusieurs détecteurs thermiques, ainsi qu'au moins un matériau à effet getter, situés dans une cavité hermétique. La cavité hermétique est délimitée par une structure d'encapsulation, laquelle comporte plusieurs couches minces transparentes au rayonnement électromagnétique à détecter, dont notamment une couche mince d'encapsulation qui s'étend continûment au-dessus du ou des détecteurs thermiques, et éventuellement continûment au-dessus et autour de ces derniers. Par couche mince, on entend une couche formée par les techniques de dépôt de matériau de la microélectronique, dont l'épaisseur est de préférence inférieure ou égale à 10µm. Par ailleurs, une couche mince est dite transparente lorsqu'elle présente un coefficient de transmission supérieur ou égal à 50%, de préférence à 75%, voire à 90% pour une longueur d'onde centrale de la gamme spectrale du rayonnement électromagnétique à détecter.

D'une manière générale, un matériau à effet getter est un matériau destiné à être exposé à l'atmosphère de la cavité hermétique et apte à réaliser un pompage gazeux par absorption et/ou adsorption. Il s'agit d'un matériau métallique qui peut être choisi parmi le titane, le zirconium, le vanadium, le chrome, le cobalt, le fer, le manganèse, le palladium, le baryum et/ou l'aluminium, voire un alliage de ces métaux tel que le TiZrV.

Par ailleurs, le procédé de fabrication comporte une étape de réalisation du ou des détecteurs thermiques au moyen d'au moins une couche sacrificielle dite minérale, réalisée en un matériau minéral ou inorganique. Il s'agit ici d'un matériau diélectrique à base de silicium permettant également la réalisation d'une couche diélectrique inter-métal du circuit de lecture, c'est-à-dire un matériau électriquement isolant, avec par exemple une constante diélectrique, ou permittivité relative, inférieure ou égale à 3,9, limitant ainsi la capacité parasite entre les interconnexions. Ce matériau minéral ne comporte pas de chaînes carbonées, et peut être un oxyde de silicium SiOx ou un nitrure de silicium SiₓN_{y}, voire un matériau organosilicié tel que du SiOC, du SiOCH, ou d'un matériau de type verre fluoré tel que du SiOF. La couche sacrificielle minérale peut être supprimée par une gravure chimique humide telle qu'une attaque chimique en milieu acide, par exemple à l'acide fluorhydrique en phase vapeur (HF vapeur). Par gravure humide, on entend d'une manière générale que l'agent de gravure se présente en phase liquide ou en phase vapeur, et ici, de préférence, en phase vapeur.

De plus, dans la mesure où la ou les couches sacrificielles minérales sont supprimées à la suite de la réalisation de la couche mince d'encapsulation, la portion getter est protégée par une portion de protection en carbone amorphe. Le carbone amorphe peut éventuellement être de type DLC (pour *Diamond Like Carbon*, en anglais), c'est-à-dire qu'il présente un fort taux d'hybridation en carbone sp³. La portion de protection est ainsi sensiblement inerte vis-à-vis de la gravure chimique humide effectuée pour supprimer la couche sacrificielle minérale. Par sensiblement inerte, on entend que le carbone amorphe ne réagit sensiblement pas avec l'agent de gravure utilisé lors de l'étape de suppression de la couche sacrificielle minérale, voire réagit peu de sorte que la portion de protection, à l'issue de cette étape de suppression, protège toujours le matériau getter. La couche mince de protection est adaptée à être supprimée par une gravure chimique telle qu'une gravure chimique sèche dont un agent de gravure est par exemple de l'oxygène contenu dans un plasma.

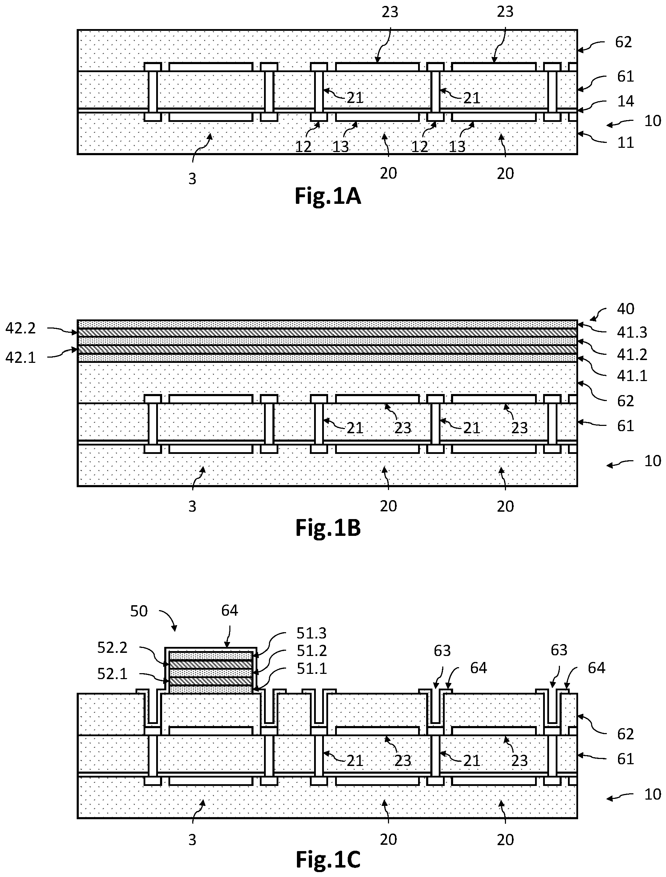

Les figures 1A à 1I illustrent différentes étapes d'un procédé de fabrication d'un dispositif de détection 1 selon un mode de réalisation. Par souci de clarté, seule une partie du dispositif de détection 1 est représentée sur les figures. Dans cet exemple, la couche mince d'encapsulation s'étend continûment au-dessus et autour des détecteurs thermiques. Cependant, d'autres configurations de la couche mince d'encapsulation sont possibles.

A titre d'exemple, les détecteurs thermiques 20 sont ici adaptés à détecter un rayonnement infrarouge dans la gamme LWIR (*Long Wavelength Infrared*, en anglais) dont la longueur d'onde est comprise entre 8µm et 14µm environ. Chaque dispositif de détection 1 comporte un ou plusieurs détecteurs thermiques 20, et ici une matrice de détecteurs thermiques identiques, connectés à un circuit de lecture situé dans le substrat 10 (dit alors substrat de lecture), et situés dans une même cavité hermétique 2. Les détecteurs thermiques 20 forment ainsi des pixels sensibles agencés périodiquement, et peuvent présenter une dimension latérale dans le plan du substrat de lecture 10, de l'ordre de quelques dizaines de microns, par exemple égale à 10µm environ voire moins. En variante, le dispositif de détection 1 peut comporter une pluralité de cavités hermétiques 2 contenant chacune un seul détecteur thermique 20.

On définit ici et pour la suite de la description un repère direct tridimensionnel XYZ, où le plan XY est sensiblement parallèle au plan du substrat de lecture 10, l'axe Z étant orienté suivant une direction sensiblement orthogonale au plan du substrat de lecture 10 en direction des détecteurs thermiques 20. Les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X,Y). Par ailleurs, les termes « inférieur » et « supérieur » s'entendent comme étant relatifs à un positionnement croissant lorsqu'on s'éloigne du substrat de lecture 10 suivant la direction +Z.

En référence à la fig. 1A, on réalise au moins un détecteur thermique 20 sur le substrat de lecture 10, et ici une pluralité de détecteurs thermiques 20, ces détecteurs thermiques 20 étant recouverts par au moins une couche sacrificielle minérale 62. Dans cet exemple, plusieurs détecteurs de compensation 3 sont également réalisés.

Le substrat de lecture 10 est réalisé à base de silicium, et est formé d'un substrat support 11 contenant le circuit de lecture (non représenté) adapté à commander et lire les détecteurs thermiques 20. Le circuit de lecture se présente ici sous la forme d'un circuit intégré CMOS. Il comporte entre autres des portions de lignes conductrices séparées les unes des autres par des couches isolantes inter-métal réalisées en un matériau diélectrique, par exemple un matériau minéral à base de silicium tel qu'un oxyde de silicium SiOₓ, un nitrure de silicium SiNₓ, entre autres. Des portions conductrices 12 affleurent la surface du substrat support 11, et assurent la connexion électrique des piliers d'ancrage 21 des détecteurs thermiques 20 au circuit de lecture. De plus, une ou plusieurs portions de connexion (non représentées) affleurent la surface du substrat support, et permettent de connecter le circuit de lecture à un dispositif électronique externe.

Le substrat de lecture 10 peut comporter un réflecteur 13 disposé en regard de chaque détecteur thermique 20. Le réflecteur 13 peut être formé par une portion d'une ligne conductrice du dernier niveau d'interconnexion, celle-ci étant réalisée en un matériau adapté à réfléchir le rayonnement électromagnétique à détecter. Il s'étend en regard de la membrane absorbante 23 du détecteur thermique 20, et est destiné à former avec celle-ci une cavité interférentielle quart d'onde vis-à-vis du rayonnement électromagnétique à détecter.

Enfin, le substrat de lecture 10 comporte ici une couche de protection 14 de manière à recouvrir notamment la couche isolante inter-métal supérieure. Cette couche de protection 14 correspond ici à une couche d'arrêt de gravure réalisée en un matériau sensiblement inerte à l'agent de gravure chimique utilisé ultérieurement pour supprimer les différentes couches sacrificielles minérales 61, 62, par exemple au milieu HF en phase vapeur. Cette couche de protection 14 forme ainsi une couche hermétique et chimiquement inerte, et électriquement isolante pour éviter tout court-circuit entre les piliers d'ancrage 21. Elle permet ainsi d'éviter que les couches isolantes inter-métal sous-jacentes ne soient gravées lors de cette étape de suppression des couches sacrificielles minérales. Elle peut être formée en un oxyde ou nitrure d'aluminium, voire en trifluorure d'aluminium, ou encore en silicium amorphe non intentionnellement dopé.

On réalise ensuite les détecteurs thermiques 20 sur le substrat de lecture 10. Ces étapes de réalisation sont identiques ou similaires à celles décrites notamment dans le document EP3239670A1. Les détecteurs thermiques 20 sont ici des microbolomètres comportant chacun une membrane absorbante 23, i.e. apte à absorber le rayonnement électromagnétique à détecter, suspendue au-dessus du substrat de lecture 10 par des piliers d'ancrage 21, et isolée thermiquement de celui-ci par des bras de maintien et d'isolation thermique (non représentés). L'obtention de membranes absorbantes 23 est classiquement obtenue par des techniques de micro-usinage de surface consistant à réaliser les piliers d'ancrage 21 au travers d'une première couche sacrificielle minérale 61, et les bras d'isolation thermique ainsi que les membranes absorbantes 23 sur la face supérieure de la couche sacrificielle minérale 61. Chaque membrane absorbante 23 comporte en outre un transducteur thermométrique, par exemple un matériau thermistance, relié au circuit de lecture par des connexions électriques prévues dans les bras d'isolation thermique et dans les piliers d'ancrage 21. Dans cet exemple, le dispositif de détection 1 comporte des détecteurs thermiques 20 optiquement actifs, c'est-à-dire destinés à détecter le rayonnement électromagnétique d'intérêt. Il comprend également un ou plusieurs détecteurs dit de compensation 3, c'est-à-dire destinés à ne pas recevoir le rayonnement électromagnétique d'intérêt. Le détecteur de compensation 3 est destiné à mesurer un signal électrique de mode commun, ce signal électrique étant à soustraire au signal électrique mesuré par les détecteurs thermiques 20 optiquement actifs.

On dépose ensuite une deuxième couche sacrificielle minérale 62 préférentiellement de même nature que la première couche sacrificielle minérale 61. La deuxième couche sacrificielle minérale 62 recouvre la couche sacrificielle minérale 61 ainsi que les détecteurs thermiques 20 et les détecteurs de compensation 3. Elle présente une face supérieure sensiblement plane, opposée au substrat de lecture 10 suivant l'axe Z. D'une manière générale, les différentes couches sacrificielles minérales 61, 62 peuvent être un oxyde de silicium obtenu à partir d'un composé TEOS (orthosilicate de tétraéthyle) déposé par PECVD.

En référence à la fig. 1B, on réalise ensuite un empilement 40 dit getter, destiné à la réalisation d'un ou plusieurs plots 50 dits getter décrits en détail par la suite. Cet empilement 40 est dit getter dans la mesure où il comporte au moins une couche mince getter 42 et au moins une couche mince de protection 41 réalisée en carbone amorphe. Il est réalisé de manière à recouvrir la face supérieure de la couche sacrificielle minérale 62, et s'étend ici en regard des détecteurs thermiques 20 optiquement actifs et des détecteurs de compensation 3. L'empilement getter 40 est formé d'un empilement suivant l'axe Z de plusieurs couches minces 41, 42 planes et parallèles entre elles, dont *a minima* une couche de protection inférieure 41.1 s'étendant sur et au contact de la couche sacrificielle minérale 62, et d'une couche getter 42. 1 reposant sur et au contact de la couche de protection inférieure 41.1. Les couches minces 41, 42 de l'empilement getter 40 sont dites planes dans la mesure où elles s'étendent de manière planaire dans le plan XY sur toute leur étendue surfacique.

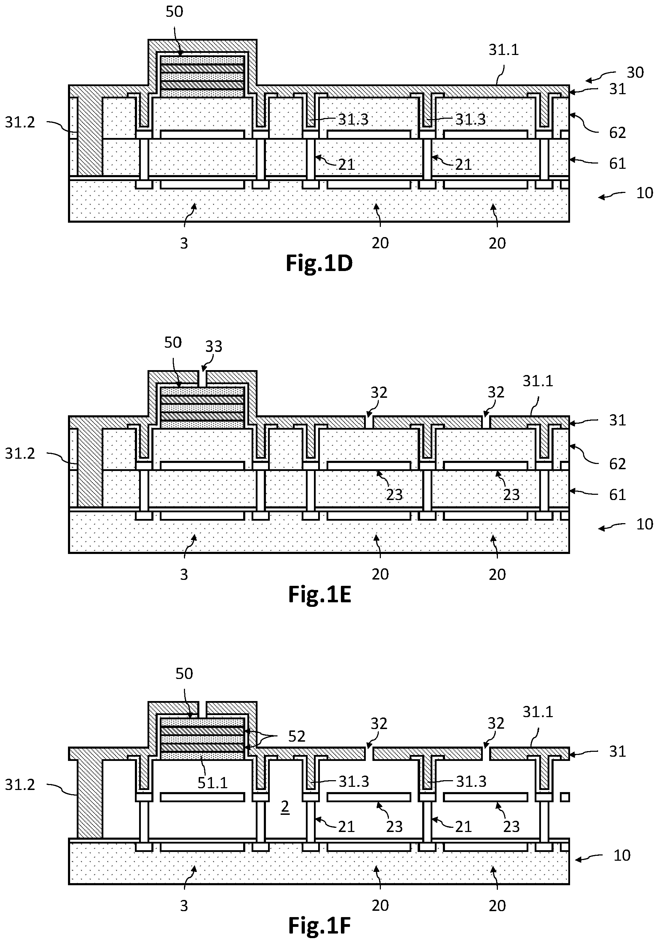

Dans cet exemple, l'empilement getter 40 comporte plusieurs couches getter 42.1, 42.2, ici deux couches, chaque couche getter 42 étant intercalée entre et au contact de deux couches de protection 41. Le nombre de couches getter 42 est choisi en fonction de la surface active souhaitée de matériau getter dans la cavité hermétique 2. Le fait qu'une couche de protection 41.3 recouvre la couche getter supérieure 42.2 est utile lorsqu'un évent 33 est présent au travers de la couche mince d'encapsulation 31 et débouche sur le plot getter 50 (cf. fig.1E). La portion getter 52.2 sous-jacente est alors protégée vis-à-vis de l'agent de gravure humide mis en oeuvre lors de l'étape de suppression des couches sacrificielles minérales 61, 62. Les couches de protection 41 sont réalisées en carbone amorphe, et peuvent présenter une épaisseur comprise entre 50nm et 500nm. Les couches getter 42 peuvent être réalisées par exemple en titane, et peuvent présenter une épaisseur comprise entre 100nm et 1µm environ, typiquement 300nm.

En référence à la fig.1C, on réalise un ou plusieurs plots 50 dits getter, par lithographie et gravure localisée de l'empilement getter 40. La gravure est réalisée de manière à graver localement l'empilement getter 40 sur toute son épaisseur, de manière à déboucher sur la couche sacrificielle minérale 62. Lorsque plusieurs plots getter 50 sont réalisés, ils sont alors distincts et distants les uns des autres dans le plan XY. Ainsi, le ou les plots getter 50 recouvrent partiellement la couche sacrificielle minérale 62. De plus, ils sont formés d'un empilement de portions 51, 52 desdites couches minces planes 41, 42, et comportent donc chacun une portion de protection inférieure 51.1 en carbone amorphe reposant sur et au contact de la couche sacrificielle minérale 62, et une portion getter 52.1 reposant sur et au contact de la portion de protection inférieure 51.1.

Les plots getter 50 sont disposés à distance dans le plan XY vis-à-vis des détecteurs thermiques 20 optiquement actifs de manière à ne pas perturber la transmission du rayonnement électromagnétique à détecter. Ils sont alors situés à une distance non nulle dans le plan XY des membranes absorbantes 23 de ces détecteurs thermiques 20, et avantageusement à une distance non nulle des bras d'isolation thermique et des piliers d'ancrage 21 de ces derniers. Dans cet exemple, ils sont disposés en regard, c'est-à-dire à la verticale suivant l'axe Z, des détecteurs de compensation 3 de manière à les écranter vis-à-vis du rayonnement électromagnétique incident.

Sur cette figure, un seul détecteur de compensation 3 et un seul plot getter 50 sont représentés, bien que plusieurs détecteurs de compensation 3 et plusieurs plots getter 50 peuvent être présents. Le ou les plots getter 50 peuvent présenter une dimension dans le plan XY de l'ordre de quelques microns à quelques dizaines de microns, de préférence inférieure ou égale à 50µm de manière à assurer un bon maintien mécanique. Le ou les plots getter 50 peuvent présenter un nombre, et un agencement dans le plan XY, variables. Ainsi, à titre d'exemple, un même plot getter 50 peut s'étendre en regard de plusieurs détecteurs de compensation 3. Dans ce cas, des ouvertures (non représentées ici) peuvent être réalisées localement dans ce plot getter 50 de grandes dimensions pour permettre la réalisation de piliers de soutien de la couche mince d'encapsulation 31. Il peut comporter plusieurs ouvertures (décrites plus loin) pour donner accès, le cas échéant, aux portions de protection 51 intercalaires. En variante, plusieurs plots getter 50 peuvent être réalisés, lesquels sont disposés à raison d'un plot getter 50 par détecteur de compensation 3. D'autres agencements sont bien sûr possibles.

De manière avantageuse, on réalise ensuite une ou plusieurs d'échancrures 63 destinées à permettre la réalisation de piliers de soutien 31.3. Ceux-ci sont particulièrement utiles lorsque la cavité hermétique 2 comporte un grand nombre de détecteurs thermiques 20. Ces échancrures 63 s'étendent à partir de la face supérieure de la couche sacrificielle minérale 62 suivant l'axe Z pour déboucher sur au moins une partie des piliers d'ancrage 21 des détecteurs thermiques 20 et/ou des détecteurs de compensation 3. On dépose ensuite une couche mince isolante 64, réalisée en un matériau électriquement isolant, sur la surface rendue libre des piliers d'ancrage 21 à l'intérieur des échancrures 63. Cette couche mince isolante 64 permet d'éviter un court-circuit électrique entre les détecteurs 3, 20 via la couche mince d'encapsulation 31 et ses piliers de soutien 31.3. La couche mince isolante 64 est de préférence gravée localement en regard des détecteurs thermiques 20, de manière à ne pas réduire la transmission du rayonnement électromagnétique à détecter. Elle peut présenter une épaisseur comprise entre 10nm et 100nm environ. Elle est réalisée en un matériau inerte à la gravure chimique humide mise en oeuvre lors de la suppression des couches sacrificielles minérales 61, 62, qui peut être choisi parmi l'AlN, l'Al₂O₃, l'HfO₂.

En référence à la fig.1D, on réalise ensuite la couche mince d'encapsulation 31 d'une structure d'encapsulation 30 de manière similaire à celle décrite dans le document EP3239670A1, ceci pour chaque matrice de détecteurs thermiques 20. Tout d'abord, par des techniques classiques de photolithographie, on grave localement les couches sacrificielles minérales 61, 62 pour former des tranchées débouchant sur le substrat de lecture 10. Les tranchées (ou la tranchée continue) forment ensemble un périmètre continu et fermé entourant dans le plan XY les détecteurs thermiques 20 et les détecteurs de compensation 3.

On procède ensuite au dépôt conforme de la couche mince d'encapsulation 31, ici du silicium amorphe d'une épaisseur de 800nm environ (mais d'autres matériaux peuvent convenir, comme du Ge ou du SiGe), qui s'étend sur la couche sacrificielle minérale 62 ainsi que dans les tranchées et ici dans les échancrures 63, par exemple par un dépôt chimique en phase vapeur (CVD pour *Chemical Vapor Deposition*, en anglais). La couche mince d'encapsulation 31 comprend donc une partie supérieure 31.1 (également appelée paroi supérieure) qui s'étend au-dessus et à distance suivant l'axe Z des détecteurs thermiques 20, et recouvre la couche sacrificielle minérale 62 ainsi que le plot getter 50. Elle comprend également une partie périphérique 31.2 (également appelée paroi périphérique) qui entoure dans le plan XY de manière continue les détecteurs thermiques 20 en étant au contact des flancs des couches sacrificielles minérales 61, 62. Elle comprend ici également des piliers de soutien 31.3 qui s'étendent suivant l'axe Z à partir de la paroi supérieure 31.1 jusqu'aux piliers d'ancrage 21. La paroi supérieure 31.1, la paroi périphérique 31.2 et les piliers de soutien 31.3 sont formés d'un seul tenant. Ainsi, la paroi supérieure 31.1 de la couche mince d'encapsulation 31 s'étend sur la face supérieure de la couche sacrificielle minérale 62, ainsi que sur les flancs et sur la face supérieure de ou des plots getter 50. Les flancs sont les surfaces d'une couche ou d'une portion de couche s'étendant suivant un axe sensiblement orthogonal au substrat et définissant une bordure dans le plan XY de la couche ou portion de couche.

En référence à la fig. 1E, on réalise les premiers évents 32 au travers de la couche mince d'encapsulation 31 débouchant sur la couche sacrificielle minérale 62 et destinés à permettre l'évacuation des différentes couches sacrificielles minérales 61, 62 hors de la cavité 2. Ils sont disposés à distance des plots getter 50. Dans cet exemple, les évents 32 sont situés à la perpendiculaire des membranes absorbantes 23 des détecteurs thermiques 20, mais ils peuvent être disposés différemment. De préférence, dans le même temps, on réalise des deuxièmes évents 33 au travers de la couche mince d'encapsulation 31 et ici de la couche mince isolante, et débouchant ici sur la portion de protection supérieure 51.3 du plot getter 50.

En référence à la fig. 1F, on effectue une première gravure chimique adaptée à supprimer les couches sacrificielles minérales 61, 62, ici par une gravure chimique humide par attaque à l'acide fluorhydrique en phase vapeur. Les produits de la réaction chimique sont évacués au travers des premiers évents 32. Cette gravure chimique humide étant isotrope, on obtient la suspension des membranes absorbantes 23, et on libère les piliers d'ancrage 21 et les bras d'isolation thermique, ainsi que les piliers de soutien 31.3. La première gravure chimique est sélective de sorte que la portion de protection inférieure 51.1 du plot getter 50 n'est pas supprimée, les portions getter 52 étant alors entièrement protégées de l'attaque HF vapeur. Ainsi, la surface inférieure de la portion de protection 51.1 est libérée, c'est-à-dire que sa surface initialement au contact de la couche sacrificielle minérale 62 est maintenant libre. La paroi supérieure 31.1 de la couche mince d'encapsulation 31 repose donc sur le substrat de lecture 10 par le biais de la paroi périphérique 31.2 et ici par le biais des piliers de soutien 31.3 qui s'appuient sur les piliers d'ancrage 21.

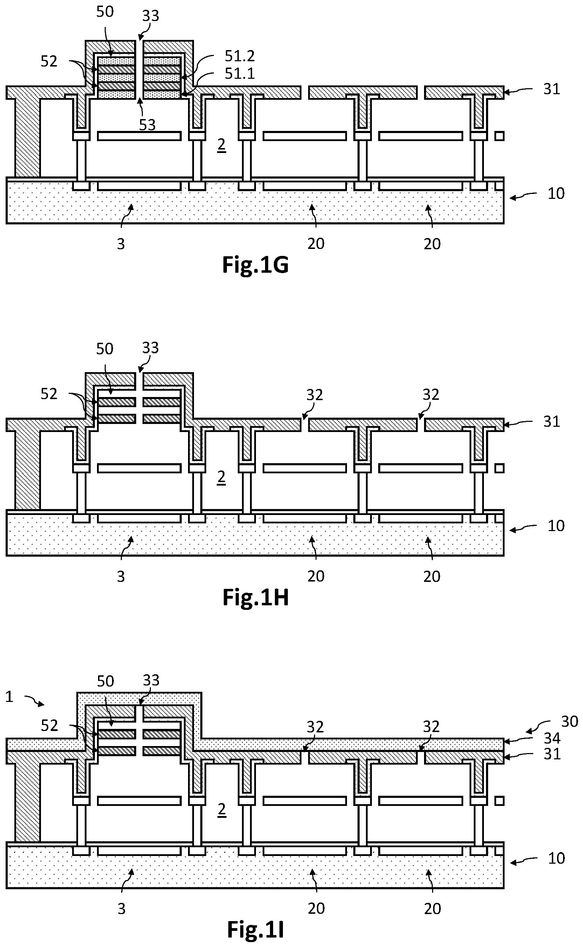

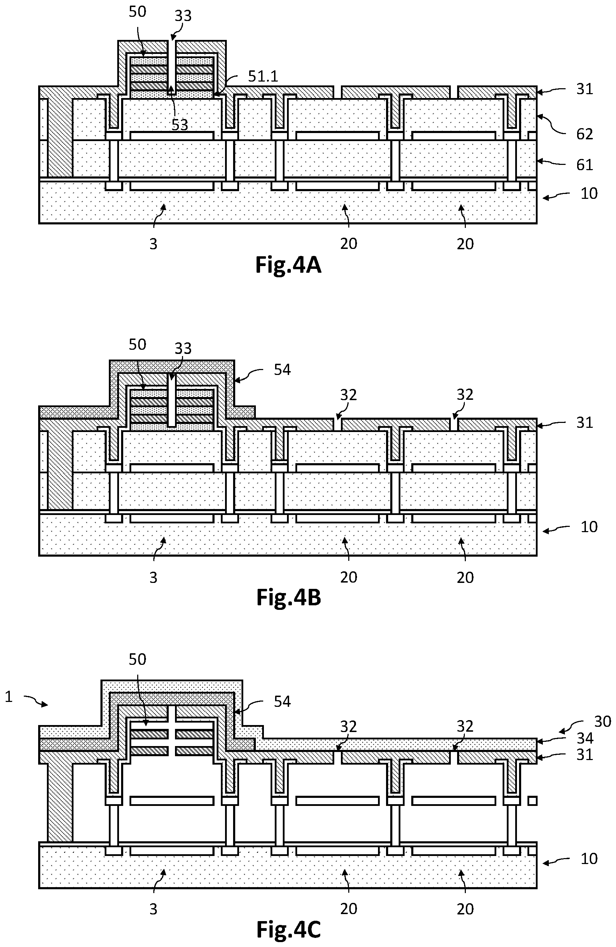

En référence à la fig. 1G, on prolonge la profondeur du deuxième évent 33 pour former au moins une ouverture 53, auto-alignée sur le deuxième évent 33, qui s'étend au travers du plot getter 50 en direction du substrat de lecture 10, de manière à permettre à l'agent de la deuxième gravure chimique d'accéder à toutes les portions de protection 51, et ici en particulier à la portion de protection intermédiaire 51.2. Dans cet exemple, l'ouverture 53 est traversante dans la mesure où elle traverse les différentes portions de protection 51 et les différentes portions getter 52. Elle peut toutefois ne pas être traversante et ne s'étendre que partiellement au travers de la portion de protection inférieure 51.1 (cf. fig.4A). Cette étape peut être réalisée à l'aide d'agents classiques de gravure sèche offrant une bonne sélectivité vis-à-vis du matériau de la couche mince d'encapsulation 31 (ici Si amorphe), par exemple des agents de gravure chlorés (Cl₂, BCl₃...).

En référence à la fig.1H, on effectue une deuxième gravure chimique adaptée à supprimer les portions de protection 51 en carbone amorphe, et donc à rendre libre des surfaces des portions getter 52. La gravure chimique est ici une gravure chimique sèche dont l'agent de gravure est par exemple de l'oxygène présent dans un plasma. Cette gravure chimique sèche étant isotrope, on préserve l'intégrité des structures libérées tout en facilitant l'accès à l'agent de gravure dans la cavité 2 au travers des premiers et deuxièmes évents 32, 33. Ainsi, les portions getter 52 sont libérées, c'est-à-dire qu'elles présentent une surface libre (non revêtue), et sont donc exposées à l'atmosphère de la cavité 2. Elles sont maintenues suspendues au-dessus du substrat de lecture 10 au niveau d'un flanc externe par la couche mince d'encapsulation 31. Ici, les portions getter 52 présentent chacune des surfaces inférieure et supérieure libres, augmentant ainsi la surface active totale du matériau getter à l'intérieur de la cavité 2.

En référence à la fig. 1I, on dépose une couche de scellement 34 sur la couche mince d'encapsulation 31 avec une épaisseur suffisante pour assurer le scellement, i.e. le bouchage, des différents évents 32, 33. La couche de scellement 34 est transparente au rayonnement électromagnétique à détecter, et peut être réalisée en germanium avec une épaisseur de 1.7µm environ. On peut également déposer une couche antireflet (non représentée) permettant d'optimiser la transmission du rayonnement électromagnétique au travers de la structure d'encapsulation. Cette couche antireflet peut être réalisée en sulfure de zinc avec une épaisseur de 1.2µm environ. On obtient ainsi une cavité hermétique 2 sous vide ou à pression réduite, dans laquelle sont logés les détecteurs thermiques 20 ainsi que les portions getter 52, celles-ci étant suspendues au-dessus du substrat de lecture 10 et maintenues par la couche mince d'encapsulation 31.

Aussi, le procédé de fabrication selon l'invention permet d'améliorer la protection de la portion getter 52 vis-à-vis de la gravure humide mise en oeuvre lors de l'étape de suppression des couches sacrificielles minérales 61, 62. En effet, dans la configuration du document EP3239670A1 mentionné précédemment où la couche sacrificielle minérale 61 est un oxyde de silicium déposé sur la couche de protection, les inventeurs ont constaté une dégradation potentielle de cette couche de protection lorsqu'elle est réalisée en carbone amorphe et que l'oxyde de silicium est notamment obtenu à partir d'un composé TEOS (orthosilicate de tétraéthyle), cette dégradation pouvant conduire à une détérioration de la portion getter 52. Au contraire, ici, la portion de protection 51 en carbone amorphe est déposée après la réalisation des couches sacrificielles minérales 61, 62, de sorte qu'elle est préservée de toute dégradation liée à l'étape de réalisation de ces couches sacrificielles minérales 61, 62.

De plus, la protection de la portion getter 52 vis-à-vis de la gravure humide est également améliorée dans la mesure où on écarte les défauts potentiels de recouvrement des portions getter 52 par les portions de protection 51. En effet, dans la configuration du document EP3239670A1 où la couche de protection est déposée sur la portion getter 52, les inventeurs ont constaté un possible défaut de recouvrement des flancs de la portion getter 52 lorsque la couche de protection est réalisée carbone amorphe. Au contraire, ici, les portions de protection 51 sont planes et ne recouvrent que les faces inférieure et/ou supérieure des portions getter 52 et non pas les flancs de celles-ci, de sorte que les risques de défauts de recouvrement sont réduits voire écartés.

Par ailleurs, le document EP2141117A1 décrit une configuration d'un détecteur thermique encapsulé dans une cavité hermétique. Une portion getter est réalisée sur une couche sacrificielle et est protégée par une couche de protection intercalaire. Les problématiques liées à l'utilisation d'un matériau de protection en carbone amorphe et d'un matériau sacrificiel minéral ne sont pas mentionnées. De plus, ce document décrit une couche de protection qui recouvre la face supérieure, mais également les flancs de la couche sacrificielle, jusqu'à s'étendre sur le substrat en bordure de la couche sacrificielle. Cette configuration conduit à obtenir une structure d'encapsulation présentant un encombrement plus important, alors que le procédé de fabrication selon l'invention permet de préserver l'encombrement réduit décrit dans le document EP3239670A1. Quoi qu'il en soit, la portion getter dans le document EP3239670A1 a été structurée afin qu'elle ne recouvre que partiellement la couche de protection. En revanche, dans le procédé selon l'invention, la couche de protection 41 et la couche getter 42 sont structurées ensemble pour former le plot getter 50. La portion getter 52 recouvre donc totalement la face supérieure de la portion de protection 51.

De plus, la couche de protection décrite dans ce document EP2141117A1 n'est pas continûment plane sur toute son étendue surfacique, de sorte que des défauts de recouvrement pourraient être présents si elle était réalisée en carbone amorphe, conduisant alors à une possible dégradation de la portion getter, en particulier lorsqu'elle est située à proximité de la partie verticale de la couche de protection. Cette situation est évitée dans le procédé de fabrication selon l'invention.

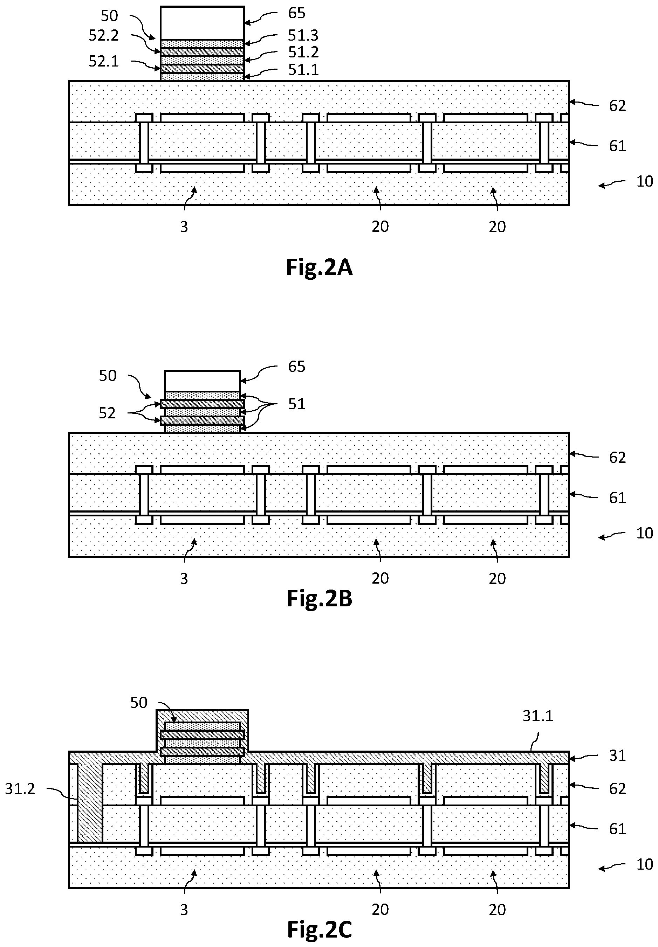

Les figures 2A à 2D illustrent différentes étapes d'un procédé de fabrication d'un dispositif de détection 1 selon une variante de mode de réalisation. Cette variante se distingue du procédé décrit précédemment essentiellement en ce qu'une sur-gravure latérale des portions de protection 51 du ou des plots getter 50 est effectuée. Seules certaines étapes sont ici détaillées, les autres étant identiques ou similaires à celles décrites précédemment.

En référence à la fig.2A, on réalise un ou plusieurs plots getter 50 sur la couche sacrificielle minérale 62, situés à distance des détecteurs thermiques 20 optiquement actifs dans le plan XY, et ici disposés en regard des détecteurs de compensation 3. Un masque 65 recouvre uniquement la face supérieure du plot getter 50 et non pas les flancs de ce dernier. Les dimensions dans le plan XY des portions de protection 51 et des portions getter 52 sont sensiblement identiques, de sorte que le plot getter 50 présente des flancs sensiblement verticaux, aux incertitudes de fabrication près.

En référence à la fig.2B, on effectue une gravure sèche isotrope, par exemple au plasma oxygène, de manière à provoquer une légère sur-gravure latérale des flancs des portions de protection 51, et non pas des flancs des portions getter 52. Aussi, les portions de protection 51 présentent des dimensions réduites dans le plan XY vis-à-vis de celles des portions getter 52. Cette topologie bidimensionnelle (suivant l'axe Z) des flancs du plot getter 50 sera mise à profit pour améliorer le maintien mécanique des portions getter 52, lorsqu'elles seront suspendues à la suite de l'étape de gravure chimique sèche.

En référence à la fig.2C, on réalise la couche mince d'encapsulation 31. Dans cet exemple, la couche mince isolante n'a pas été représentée sur les flancs du plot getter 50, par souci de clarté. Elle peut être présente et ne pas s'étendre sur le plot getter 50. Aussi, la paroi supérieure 31.1 de la couche mince d'encapsulation 31 s'étend de manière à recouvrir les flancs à topologie bidimensionnelle du plot getter 50, de sorte que la surface de maintien mécanique est plus importante que dans l'exemple des fig.1A à 1I.

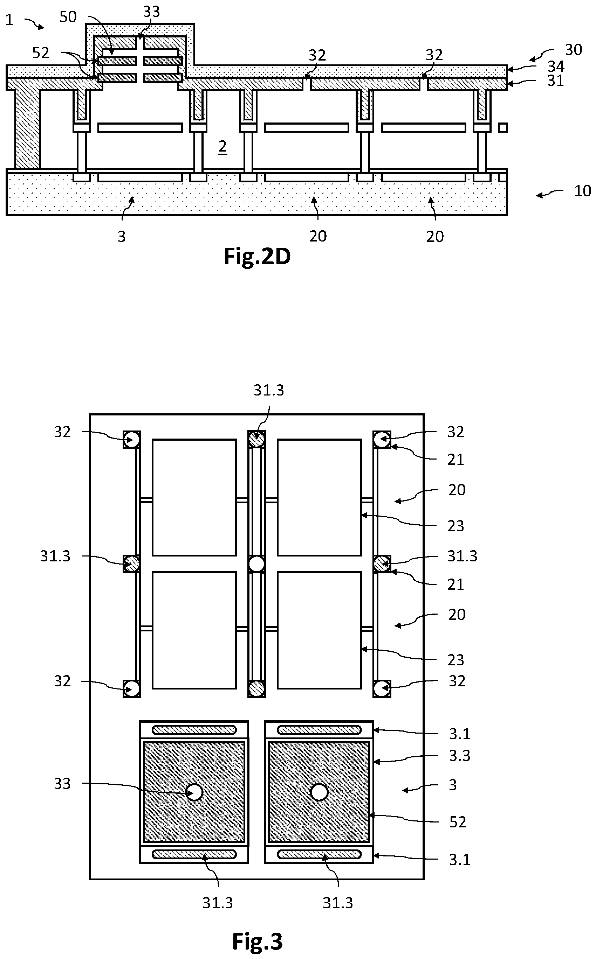

En référence à la fig.2D, après avoir réalisé les différents évents 32, 33 et ouvertures 53, et procédé à la suppression des couches sacrificielles minérales 61, 62 par gravure humide et à la suppression des portions de protection 51 par gravure sèche, on dépose la couche mince de scellement 34. La structure d'encapsulation 30 ainsi obtenue se distingue essentiellement ici de celle décrite sur la fig.1I en ce que la couche mince d'encapsulation 31 recouvre ici une bordure externe des faces inférieure et supérieure des portions getter 52, du fait de la topologie bidimensionnelle initiale des flancs du plot getter 50. Ainsi, le maintien mécanique des portions getter 52 ainsi suspendues est amélioré.

La figure 3 est une vue de dessus, schématique et partielle, d'un exemple d'agencement des détecteurs thermiques 20 et des détecteurs de compensation 3, ainsi que des portions getter 52.

Les détecteurs thermiques 20 comportent chacun une membrane absorbante 23 suspendue au-dessus du substrat de lecture 10 par des piliers d'ancrage 21 et des bras de maintien et d'isolation thermique 22. Des piliers de soutien 31.3 sont ici agencés de manière à reposer sur une partie des piliers d'ancrage 21. Ici, un pilier d'ancrage 21 sur deux, suivant l'axe X et suivant l'axe Y, reçoivent un pilier de soutien 31.3. Les premiers évents 32 sont disposés ici en regard des autres piliers d'ancrage 31.3. D'autres agencements des premiers évents 32 sont bien entendu possibles.

Les détecteurs de compensation 3 comportent chacun une membrane 3.3 sensiblement identique aux membranes absorbantes 23, mais qui est destinée à ne pas recevoir le rayonnement électromagnétique à détecter. Ces membranes 3.3 sont suspendues au-dessus du substrat de lecture 10 par des piliers d'ancrage 3.1. Dans cette configuration, les membranes 3.3 ne sont pas isolées thermiquement du substrat de lecture 10 par des bras de maintien. Des piliers de soutien 31.3 sont ici agencés de manière à reposer sur les piliers d'ancrage 3.1. Les portions getter 52 sont ici situées en regard des membranes 3.3, et présentent des dimensions choisies de manière à écranter les membranes vis-à-vis du rayonnement électromagnétique. Les évents 33 sont ici situées au centre des portions getter 52.

Ainsi, la surface active de la ou des portions getter 52 peut être importante, tout en limitant l'encombrement et la taille de la structure d'encapsulation. Le fait de superposer plusieurs portions getter 52 les unes au-dessus des autres permet d'augmenter la surface active du matériau getter sans avoir à augmenter la taille de la cavité hermétique 2.

Les figures 4A à 4C illustrent différentes étapes d'un procédé de fabrication d'un dispositif de détection 1 selon une autre variante de mode de réalisation. Cette variante se distingue du procédé décrit précédemment sur les fig. 1A à 1I essentiellement en ce qu'une deuxième couche mince de scellement 54 est utilisée pour obturer le deuxième évent 33. Seules certaines étapes sont ici détaillées, les autres étant identiques ou similaires à celles décrites précédemment.

En référence à la fig.4A, on réalise une structure globale similaire à celle décrite sur la fig.1E. Cependant, au lieu de poursuivre avec la suppression des couches sacrificielles minérales 61, 62, on réalise l'ouverture 53 auto-alignée s'étendant au travers du plot getter 50 à partir du deuxième évent 33. Dans cet exemple, l'ouverture 53 n'est pas traversante, mais débouche sur la portion de protection inférieure 51.1.

En référence à la fig.4B, on dépose une couche mince de scellement 54 sur la couche mince d'encapsulation 31 de manière à obturer le deuxième évent 33. Cette couche de scellement 54 est de préférence gravée localement de manière à ne garder qu'une partie recouvrant le plot getter 50 et à supprimer la partie située en regard des détecteurs thermiques 20, en particulier lorsqu'elle est réalisée en un matériau non transparent au rayonnement électromagnétique à détecter. Les évents 32 ne sont donc pas obturés par la couche mince de scellement 54.

En référence à la fig.4C, après avoir réalisé la suppression des couches sacrificielles minérales 61, 62 par gravure humide et la suppression des portions de protection 51 par gravure sèche, on dépose la couche mince de scellement 34 de manière à obturer les évents 32. La structure d'encapsulation 30 ainsi obtenue se distingue essentiellement ici de celle décrite sur la fig.1I en ce qu'elle comporte une deuxième couche mince de scellement 54 recouvrant le plot getter 50 initial, distincte de la couche mince de scellement 34, et de préférence ne s'étendant pas en regard des détecteurs thermiques 20.

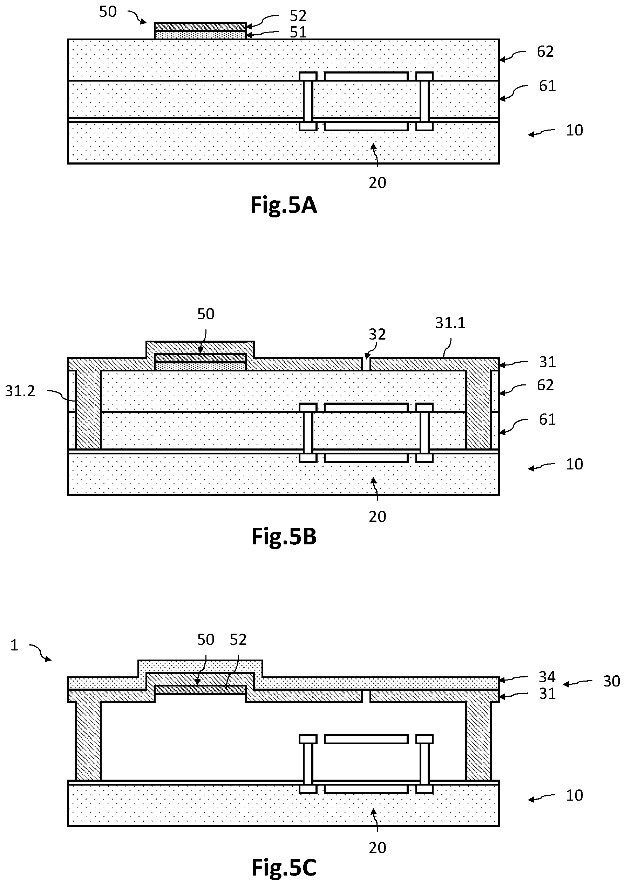

Les figures 5A à 5C illustrent différentes étapes d'un procédé de fabrication d'un dispositif de détection 1 selon une autre variante de mode de réalisation. Cette variante se distingue du procédé décrit précédemment sur les fig.1A à 1I essentiellement en ce que le dispositif de détection 1 ne comporte pas de détecteurs de compensation 3 (mais pourrait en comporter), et en ce que le plot getter 50 comporte une seule portion de protection 51 en carbone amorphe et une seule portion getter 52. Seules certaines étapes sont ici détaillées, les autres étant identiques ou similaires à celles décrites précédemment.

En référence à la fig.5A, on réalise un plot getter 50 à partir de l'empilement getter 40, de sorte qu'il soit situé à distance dans le plan XY des détecteurs thermiques 20 optiquement actifs et repose uniquement sur la face supérieure de la couche sacrificielle minérale 62. Il est formé d'une portion de protection 51 en carbone amorphe qui repose sur et au contact de la face supérieure plane de la couche sacrificielle minérale 62. Une portion getter 52 recouvre uniquement la face supérieure de la portion de protection 51, et ne s'étend donc pas au contact des flancs de celle-ci ni au contact de la couche sacrificielle minérale 62.

En référence à la fig.5B, on réalise la couche mince d'encapsulation 31, de sorte que la paroi supérieure 31.1 recouvre la face supérieure de la couche sacrificielle minérale 62 ainsi que le plot getter 50, et que la paroi périphérique 31.2 s'étend dans les tranchées et au contact des couches sacrificielles minérales 61, 62. Un évent 32 est réalisé au travers de la couche mince d'encapsulation 31 de sorte qu'il débouche sur la couche sacrificielle minérale 62. Il est situé à distance du plot getter 50.

En référence à la fig.5C, on supprime les couches sacrificielles minérales 61, 62 par une gravure humide, ici à l'HF vapeur. La portion de protection 51 présente une surface inférieure rendue libre, mais la portion getter 52 reste protégée lors de cette étape. On supprime ensuite la portion de protection 51 en carbone amorphe par une gravure sèche, ici au plasma oxygène, de sorte à rendre libre une surface inférieure de la portion getter 52. On dépose ensuite la couche mince de scellement 34 et la couche antireflet.

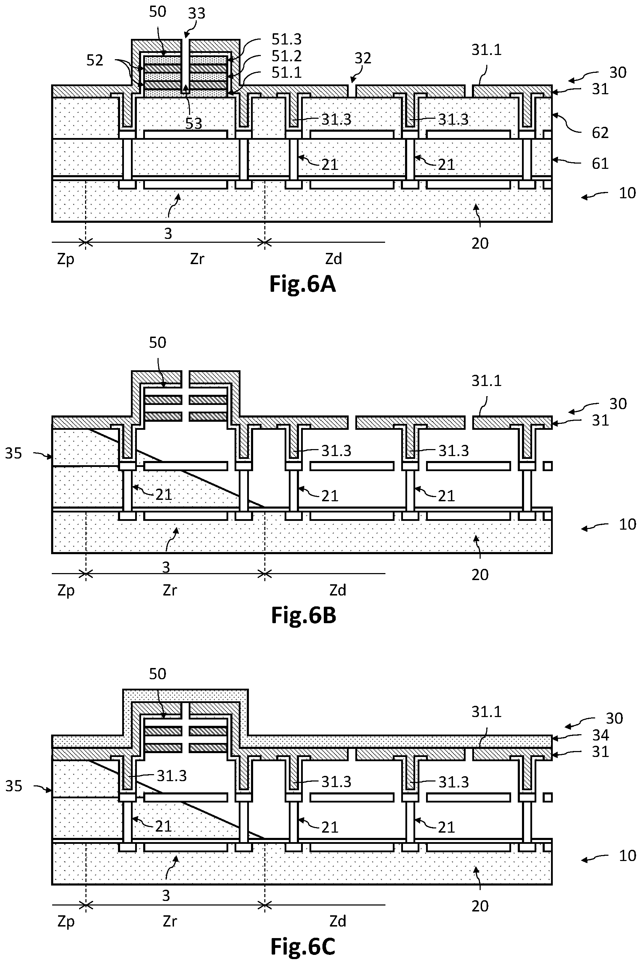

Les figures 6A à 6C illustrent différentes étapes d'un procédé de fabrication d'un dispositif de détection 1 selon une autre variante de mode de réalisation. Cette variante se distingue de celles décrites précédemment essentiellement en ce que la structure d'encapsulation comporte une paroi périphérique réalisée en un matériau minéral. Cette variante de réalisation est notamment décrite dans la demande de brevet français FR2003858 déposée le 16/05/2020, laquelle est incorporée ici par référence.

Plus précisément, comme l'illustre la fig.6C, la paroi périphérique 35, qui entoure continûment les détecteurs thermiques 20 et ici les détecteurs de compensation 3 et ainsi délimite latéralement la cavité 2, n'est plus réalisée d'un seul tenant et en le même matériau que la paroi supérieure 31.1 de la couche d'encapsulation 31. Autrement dit, elle n'est pas une partie de la couche d'encapsulation 31. Elle est réalisée en un matériau différent, ici en un matériau minéral, dans la mesure où elle est issue de portions non gravées des couches sacrificielles minérales 61 et 62.

La fig.6A illustre une étape similaire à celle décrite en référence à la fig.4A. Elle s'en distingue en ce que la couche d'encapsulation 31 ne comporte pas de paroi périphérique qui s'étend au travers des couches sacrificielles 61 et 62 pour venir au contact du substrat 10. Au contraire, elle ne comporte que la paroi supérieure 31.1, ainsi que les piliers de soutien 31.3. On a réalisé les évents 32 qui sont disposés uniquement dans une zone centrale Zd, ainsi que l'évent 33 qui forme l'ouverture 53. L'ouverture 53 n'est pas traversante mais débouche sur la portion de protection inférieure 51.1.

La surface du substrat 10 présente en effet plusieurs zones :
- une zone centrale Zd dite de détection, dans laquelle est située la matrice de détecteurs thermiques 20 (sensibles), c'est-à-dire les pixels de détection. La surface du substrat de lecture 10 dans la zone de détection Zd est destinée à être libérée entièrement des couches sacrificielles minérales 61, 62, pour ne pas être recouverte par la paroi périphérique 35 ;
- une zone intermédiaire Zr dite de renfort, qui entoure continûment la zone de détection Zd dans le plan XY, et dans laquelle peuvent se trouver les détecteurs factices 3. Elle est destinée à être recouverte par la paroi périphérique 35 ;
- une zone périphérique Zp qui entoure continûment la zone de renfort Zr dans le plan XY, et dans laquelle la paroi supérieure 31.1 de la couche mince d'encapsulation 31 est destinée à s'étendre sur et au contact de la paroi périphérique 35.

En référence à la fig.6B, on effectue une gravure chimique adaptée à supprimer partiellement, à partir des évents 32, les couches sacrificielles minérales 61, 62. La gravure chimique est une gravure humide en milieu acide, par exemple à l'acide fluorhydrique en phase vapeur. Les produits de la réaction chimique sont évacués au travers des évents 32.

Du fait de la disposition des évents 32 uniquement en regard de la zone de détection Zd, l'agent de gravure supprime entièrement les couches sacrificielles minérales 61, 62 situées dans la zone de détection Zd, mais la gravure chimique est effectuée de sorte que l'agent de gravure ne grave pas une portion périphérique des couches sacrificielles minérales 61, 62 qui s'étend autour de la zone de détection Zd. La portion non gravée des couches sacrificielles minérales 61, 62, sur laquelle repose la portion supérieure 31.1 de la couche mince d'encapsulation 31, définit la zone périphérique Zp. Elle forme la paroi périphérique 35.

La paroi périphérique 35 présente un retrait latéral, de sorte que la cavité 2 présente un élargissement vertical, c'est-à-dire qu'elle présente une forme évasée suivant la direction +Z. Les dimensions de la cavité 2 dans le plan XY sont plus importantes au niveau de la portion supérieure 31.1 qu'au niveau de la surface libérée du substrat de lecture 10. Ce profil de gravure des couches sacrificielles minérales 61, 62 est obtenu lorsque les couches sacrificielles sont réalisées en un matériau minéral et que la gravure est une gravure chimique en milieu acide en milieu confiné.

On effectue ensuite par gravure sèche, comme décrit précédemment, la suppression des portions de protection 51 qui encadrent les portions getter 52.

En référence à la fig.6C, on dépose ensuite la couche de scellement 34 qui vient obturer les évents 32 et 33. Des piliers de renfort 31.3 peuvent ainsi être présents dans la zone intermédiaire Zr et reposer sur le substrat 10. Dans cet exemple, ils reposent indirectement sur le substrat 10, ici via les piliers 21 des détecteurs factices 3. En variante, ils peuvent reposer directement sur le substrat 10, en traversant verticalement la paroi périphérique 35 pour venir contacter le substrat 10. Quoi qu'il en soit, la présence des piliers de renfort 31.3 dans la zone intermédiaire Zr permet d'améliorer la tenue mécanique de la structure d'encapsulation 30, dans la mesure où ils peuvent être au contact et traverser au moins en partie la paroi périphérique 35, ce qui assure une meilleure transmission des contraintes mécaniques entre la structure d'encapsulation 30 et le substrat 10.

Dans cette variante de réalisation, la tenue mécanique de la structure d'encapsulation 30 sur le substrat 10 est améliorée, dans la mesure où le contact sur le substrat 10 est assuré par une paroi périphérique 35 de plus grande dimension latérale que la paroi périphérique 31.2. On limite ainsi les risques de décollement de la structure d'encapsulation 30 vis-à-vis du substrat 10.

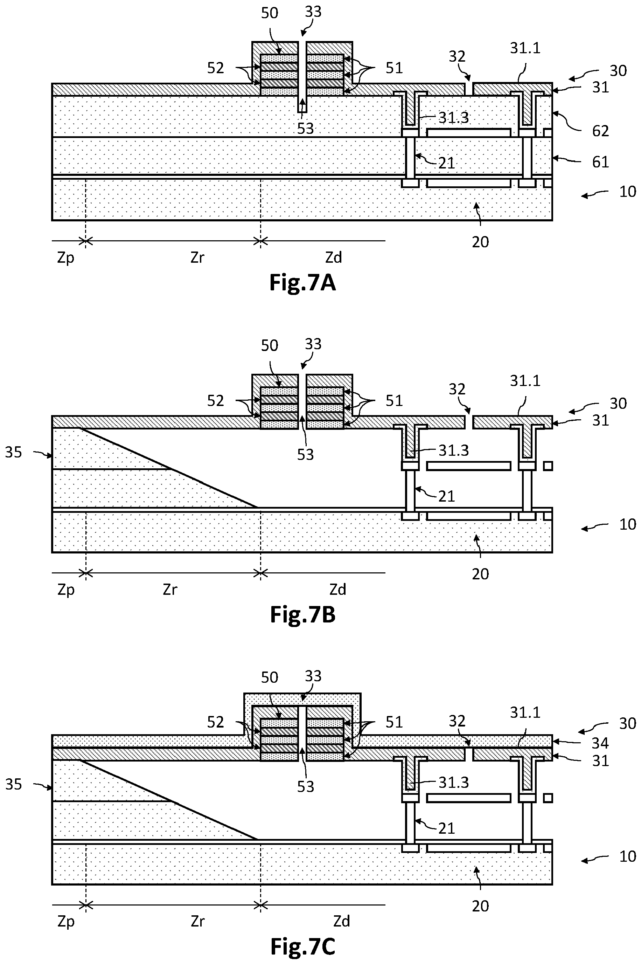

Les figures 7A à 7C illustrent différentes étapes d'un procédé de fabrication d'un dispositif de détection 1 selon une autre variante de mode de réalisation. Cette variante se distingue de celle décrite en référence aux fig.6A à 6C essentiellement en ce que l'ouverture 53 est traversante, permettant ainsi au matériau sacrificiel minéral des couches 61 et 62 d'être évacué au travers des évents 33 en plus des évents 32.

La fig.7A illustre ainsi une étape où l'on a réalisé les évents 32 en regard des détecteurs sensibles 20, et les évents 33 au-dessus des plots getter 50. L'ouverture 53 est rendue traversante et débouche sur la couche sacrificielle 62. Elle peut s'étendre partiellement dans cette couche 62. Dans cet exemple, le dispositif de détection ne comporte pas de détecteurs factices 3 sous les plots getter 50, mais en variante il peut en comporter (comme illustré sur la fig.6A).

La fig.7B illustre une étape où l'on a supprimé partiellement les couches sacrificielles 61 et 62 par gravure humide en milieu acide, de manière à former la paroi périphérique 35. Le matériau sacrificiel minéral est ici évacué au travers des évents 32 et des évents 33.

La fig.7C illustre une étape où l'on a déposé la couche de scellement 34 sur la paroi supérieure 31.1 de manière à obturer les évents 32 et 33.

Dans cette variante, la paroi périphérique 35 est située en retrait latéral vis-à-vis des détecteurs sensibles 20 et des plots getter 50, dans la mesure où les évents 33 ont participé à évacuer le matériau sacrificiel minéral des couches 61 et 62.

## Revendications

1. Procédé de fabrication d'un dispositif de détection (1) d'un rayonnement électromagnétique, comportant les étapes suivantes :
o réalisation d'au moins un détecteur thermique (20) destiné à détecter le rayonnement électromagnétique, reposant sur un substrat (10), et recouvert par une couche sacrificielle minérale (62) en un matériau minéral apte à être supprimé par une première gravure chimique ;
o réalisation d'au moins un plot dit getter (50) :
• s'étendant partiellement sur la couche sacrificielle minérale (62), et étant disposé à distance du détecteur thermique (20) dans un plan parallèle au substrat (10),
• formé d'un empilement de portions (51, 52) de couches minces planes parallèles entre elles, dont une portion de protection (51.1) en carbone amorphe apte à être supprimé par une deuxième gravure chimique et reposant au contact de la couche sacrificielle minérale (62), et au moins une portion getter (52.1) en un matériau getter reposant au contact de la portion de protection (51.1) ;
o réalisation d'une couche mince d'encapsulation (31) s'étendant au-dessus du détecteur thermique, comportant une partie supérieure (31.1) reposant sur la couche sacrificielle minérale (62) et recouvrant une face supérieure et des flancs du plot getter (50) ;
o réalisation d'au moins un premier évent (32) au travers de la couche mince d'encapsulation (31), situé à distance du plot getter (50) dans un plan parallèle au substrat (10) et débouchant sur la couche sacrificielle minérale (62) ;
o suppression de la couche sacrificielle minérale (62) par la première gravure chimique, libérant ainsi une surface de la portion de protection (51) ;
o suppression de la portion de protection (51) par une deuxième gravure chimique, libérant ainsi une surface de la portion getter (52) ;
o dépôt d'une couche mince de scellement (34) sur la couche mince d'encapsulation (31), de manière à obturer au moins le premier évent (32).

2. Procédé de fabrication selon la revendication 1, comportant une étape de réalisation d'au moins un détecteur de compensation (3) destiné à ne pas recevoir le rayonnement électromagnétique à détecter, le plot getter (50) étant disposé en regard du détecteur de compensation (3).

3. Procédé de fabrication selon la revendication 2, une pluralité de détecteurs thermiques (20) et de détecteurs de compensation (3) étant réalisés, au moins un plot getter (50) étant disposé en regard des détecteurs de compensation (3).

4. Procédé de fabrication selon l'une quelconque des revendications 2 ou 3, le détecteur thermique (20) et le détecteur de compensation (3) comportant chacun une membrane (23, 3.3) suspendue au-dessus du substrat par des piliers d'ancrage (21, 3.1), la couche mince d'encapsulation (31) comportant au moins un pilier de soutien (31.3) réalisé d'un seul tenant avec la partie supérieure (31.1), et s'étendant à partir de la partie supérieure (31.1) jusqu'à reposer sur un pilier d'ancrage (21, 3.1).

5. Procédé de fabrication selon la revendication 4, comportant une étape de réalisation d'une couche (64) en un matériau électriquement isolant disposée entre et au contact du pilier de soutien (31.3) et du pilier d'ancrage (21, 3.1).

6. Procédé de fabrication selon l'une quelconque des revendications 1 à 5, à la suite de l'étape de réalisation de la couche mince d'encapsulation (31), la couche mince d'encapsulation (31) s'étend continûment au-dessus et autour du détecteur thermique (20), et est formée de la partie supérieure (31.1) et d'une partie périphérique (31.2) réalisées d'un seul tenant, la partie périphérique (31.2) de la couche mince d'encapsulation (31) s'étendant dans une tranchée réalisée au travers de la couche sacrificielle minérale (62) et au contact des flancs de celle-ci, la partie périphérique (31.2) reposant sur le substrat (10).

7. Procédé de fabrication selon l'une quelconque des revendications 1 à 5, dans lequel :
o lors de la réalisation du détecteur thermique (20), celui-ci repose sur une première couche sacrificielle minérale (61), le détecteur thermique (20) et la première couche sacrificielle minérale (61) étant recouverts par une deuxième couche sacrificielle minérale (62), les première et deuxième couches sacrificielles minérales (61, 62) étant en un matériau minéral apte à être supprimé par la première gravure chimique ;
o le premier évent (32) est disposé en regard du détecteur thermique (20) ou le cas échéant en regard d'une matrice de détecteurs thermiques (20) ;
o lors de la première gravure chimique, celle-ci étant une gravure humide en milieu acide, les première et deuxième couches sacrificielles minérales (61, 62) sont supprimées partiellement au travers du premier évent (32), une portion non gravée des première et deuxième couches sacrificielles minérales (61, 62) formant une paroi périphérique (35) qui entoure le détecteur thermique (20) dans un plan parallèle au substrat (10) et sur laquelle repose la partie supérieure (31.1).

8. Procédé de fabrication selon la revendication 7, dans lequel, à la suite de la première gravure chimique, la paroi périphérique (35) présente un retrait latéral se traduisant par un élargissement vertical de la cavité (2) parallèlement au substrat de lecture (10), entre le substrat de lecture (10) et la partie supérieure (31.1), ce retrait latéral définissant une zone intermédiaire (Zr) d'une surface du substrat de lecture (10) entourant le détecteur thermique.

9. Procédé de fabrication selon la revendication 8, comportant une étape de réalisation de piliers de renfort (31.3) de la couche mince d'encapsulation (31), agencés dans la zone intermédiaire (Zr) autour du détecteur thermique (20), distincts les uns des autres, et s'étendant à partir de la partie supérieure (31.1) jusqu'à reposer sur le substrat de lecture (10).

10. Procédé de fabrication selon l'une quelconque des revendications 1 à 9, dans lequel le plot getter (50) comporte plusieurs portions getter (52) superposées suivant un axe perpendiculaire au substrat (10), chacune étant disposée entre deux portions de protection (51).

11. Procédé de fabrication selon l'une quelconque des revendications 1 à 10, dans lequel la portion getter (52) recouvre entièrement une face de la portion de protection (51) opposée au substrat (10).

12. Procédé de fabrication selon la revendication 11, dans lequel, lors de l'étape de réalisation du premier évent (32), au moins un deuxième évent (33) est réalisé au travers de la couche mince d'encapsulation (31) de manière à déboucher sur une portion de protection supérieure (51.3) recouvrant lesdites portions getter (52), puis, à la suite de l'étape de suppression de la couche sacrificielle minérale (62), une ouverture (53) est réalisée à partir du deuxième évent (33) de manière à déboucher sur une portion de protection inférieure (51.1), sur laquelle reposent lesdites portions getter (52).

13. Procédé de fabrication selon la revendication 12, dans lequel une deuxième couche mince de scellement (54) est déposée de manière à obturer le deuxième évent (33), cette deuxième couche mince de scellement (54) étant distincte de la couche mince de scellement (34) obturant le premier évent (32).

14. Procédé de fabrication selon l'une quelconque des revendications 1 à 13, dans lequel le plot getter (50) comporte plusieurs portions getter (52) et plusieurs portions de protection (51) superposées suivant un axe perpendiculaire au substrat (10), et dans lequel une sur-gravure latérale des portions de protection (51) est effectuée de manière sélective vis-à-vis des portions getter (52).

15. Procédé de fabrication selon l'une quelconque des revendications 1 à 14, dans lequel la couche sacrificielle minérale (62) est réalisée en un oxyde de silicium obtenu à partir d'un orthosilicate de tétraéthyle.

## Patentansprüche

1. Verfahren zur Herstellung einer Vorrichtung (1) zum Nachweis elektromagnetischer Strahlung, das die folgenden Schritte umfasst:
- Herstellung mindestens eines thermischen Detektors (20) zum Erfassen der elektromagnetischen Strahlung, der auf einem Substrat (10) ruht und mit einer mineralischen Opferschicht (62) aus einem mineralischen Material bedeckt ist, das durch eine erste chemische Ätzung entfernt werden kann;
- Herstellung von mindestens einem sogenannten Getterplot (50):
-- der sich teilweise über die mineralische Opferschicht (62) erstreckt und in einer Ebene parallel zu dem Substrat (10) entfernt von dem thermischen Detektor (20) angeordnet ist,
-- gebildet aus einem Stapel von Abschnitten (51, 52) aus ebenen, zueinander parallelen dünnen Schichten, von denen ein Schutzabschnitt (51.1) aus amorphem Kohlenstoff, der durch ein zweites chemisches Ätzen entfernt werden kann und in Kontakt mit der mineralischen Opferschicht (62) liegt, und mindestens ein Getterabschnitt (52.1) aus einem Gettermaterial in Kontakt mit dem Schutzabschnitt (51.1) liegen;
- Herstellung einer dünnen Einkapselungsschicht (31), die sich über den thermischen Detektor erstreckt, mit einem oberen Teil (31.1), der auf der mineralischen Opferschicht (62) ruht und eine obere Fläche und Flanken des Getterplots (50) bedeckt;
- Herstellung mindestens einer ersten Lüftungsöffnung (32) durch die dünne Einkapselungsschicht (31), die in einer Ebene parallel zum Substrat (10) vom Getterplot (50) beabstandet ist und in die mineralische Opferschicht (62) mündet;
- Entfernen der mineralischen Opferschicht (62) durch das erste chemische Ätzen, wodurch eine Oberfläche des Schutzabschnitts (51) freigegeben wird;
- Entfernen des Schutzabschnitts (51) durch ein zweites chemisches Ätzen, wodurch eine Oberfläche des Getterabschnitts (52) freigegeben wird;
- Auftragen einer dünnen Versiegelungsschicht (34) auf die dünne Einkapselungsschicht (31), um mindestens die erste Lüftungsöffnung (32) zu verschließen.

2. Herstellungsverfahren nach Anspruch 1, mit einem Schritt zur Herstellung mindestens eines kompensierenden Detektors (3), der dazu bestimmt ist, die zu erfassende elektromagnetische Strahlung nicht zu empfangen, wobei der Getterplot (50) gegenüber dem kompensierenden Detektor (3) angeordnet ist.

3. Herstellungsverfahren nach Anspruch 2, wobei eine Vielzahl von thermischen Detektoren (20) und kompensierenden Detektoren (3) hergestellt werden, wobei mindestens ein Getterplot (50) gegenüber den kompensierenden Detektoren (3) angeordnet ist.

4. Herstellungsverfahren nach einem der Ansprüche 2 oder 3, wobei der thermische Detektor (20) und der kompensierende Detektor (3) jeweils eine Membran (23, 3.3) umfassen, die über dem Substrat durch Verankerungssäulen (21, 3. 1) hängt, wobei die dünne Einkapselungsschicht (31) mindestens eine Tausendstütze (31.3) umfasst, die integral mit dem oberen Teil (31.1) hergestellt ist und sich von dem oberen Teil (31.1) aus erstreckt, bis sie auf einem Verankerungspfeiler (21, 3.1) ruht.

5. Herstellungsverfahren nach Anspruch 4, das einen Schritt zur Herstellung einer Schicht (64) aus einem elektrisch isolierenden Material umfasst, die zwischen und in Kontakt mit dem Stützpfeiler (31.3) und dem Verankerungspfeiler (21, 3.1) angeordnet ist.

6. Herstellungsverfahren nach einem der Ansprüche 1 bis 5, wobei im Anschluss an den Schritt der Herstellung der dünnen Einkapselungsschicht (31) sich die dünne Einkapselungsschicht (31) kontinuierlich über und um den thermischen Detektor (20) erstreckt und aus dem oberen Teil (31. 1) und einem Umfangsabschnitt (31.2), die einstückig hergestellt sind, wobei der Umfangsabschnitt (31.2) der dünnen Einkapselungsschicht (31) sich in einem Graben erstreckt, der durch die mineralische Opferschicht (62) und in Kontakt mit deren Flanken hergestellt ist, wobei der Umfangsabschnitt (31.2) auf dem Substrat (10) ruht.

7. Herstellungsverfahren nach einem der Ansprüche 1 bis 5, wobei:
- bei der Herstellung des thermischen Detektors (20) dieser auf einer ersten mineralischen Opferschicht (61) ruht, wobei der thermische Detektor (20) und die erste mineralische Opferschicht (61), der thermische Detektor (20) und die erste mineralische Opferschicht (61) von einer zweiten mineralischen Opferschicht (62) bedeckt sind, wobei die erste und die zweite mineralische Opferschicht (61, 62) aus einem mineralischen Material bestehen, das durch das erste chemische Ätzen entfernt werden kann;
- die erste Lüftungsöffnung (32) gegenüber dem thermischen Detektor (20) oder gegebenenfalls gegenüber einer Matrix von thermischen Detektoren (20) angeordnet ist;
- bei der ersten chemischen Ätzung, wobei diese eine Nassätzung in einem sauren Medium ist, die erste und zweite mineralische Opferschicht (61, 62) teilweise durch die erste Lüftungsöffnung (32) entfernt werden, wobei ein nicht geätzter Abschnitt der ersten und zweiten mineralischen Opferschicht (61, 62) eine Umfangswand (35) bildet, die den thermischen Detektor (20) in einer Ebene parallel zum Substrat (10) umgibt und auf der der obere Teil (31.1) ruht.

8. Herstellungsverfahren nach Anspruch 7, bei dem die Umfangswand (35) nach dem ersten chemischen Ätzen eine seitliche Schrumpfung aufweist, die sich in einer vertikalen Erweiterung des Hohlraums (2) parallel zum Lesesubstrat (10) zwischen dem Lesesubstrat (10) und dem oberen Teil (31.1) äußert, wobei diese seitliche Schrumpfung eine Zwischenzone (Zr) einer Oberfläche des Lesesubstrats (10) bestimmt, die den thermischen Detektor umgibt.

9. Herstellungsverfahren nach Anspruch 8, mit einem Schritt zur Herstellung von Stützpfeilern (31.3) der dünnen Einkapselungsschicht (31), die in der Zwischenzone (Zr) um den thermischen Detektor (20) herum angeordnet sind, sich voneinander unterscheiden und sich vom oberen Teil (31.1) aus erstrecken, bis sie auf dem Lesesubstrat (10) ruhen.

10. Herstellungsverfahren nach einem der Ansprüche 1 bis 9, wobei der Getterplot (50) mehrere Getterabschnitte (52) aufweist, die entlang einer Achse senkrecht zum Substrat (10) übereinander angeordnet sind, wobei jeder Getterabschnitt zwischen zwei Schutzabschnitten (51) angeordnet ist.

11. Herstellungsverfahren nach einem der Ansprüche 1 bis 10, wobei der Getterabschnitt (52) eine dem Substrat (10) abgewandte Seite des Schutzabschnitts (51) vollständig bedeckt.

12. Herstellungsverfahren nach Anspruch 11, bei dem während des Schritts der Herstellung der ersten Lüftungsöffnung (32) mindestens eine zweite Lüftungsöffnung (33) durch die dünne Einkapselungsschicht (31) hindurch hergestellt wird, so dass sie zu einem oberen Schutzabschnitt (51. 3) führt, der die Getterabschnitte (52) bedeckt, und dann, im Anschluss an den Schritt des Entfernens der mineralischen Opferschicht (62), eine Öffnung (53) ausgehend von der zweiten Lüftungsöffnung (33) hergestellt wird, so dass sie in einen unteren Schutzabschnitt (51.1) führt, auf dem die Getterabschnitte (52) ruhen.

13. Herstellungsverfahren nach Anspruch 12, bei dem eine zweite dünne Dichtungsschicht (54) aufgebracht wird, um die zweite Lüftungsöffnung (33) zu verschließen, wobei sich diese zweite dünne Dichtungsschicht (54) von der dünnen Dichtungsschicht (34), die die erste Lüftungsöffnung (32) verschließt, unterscheidet.

14. Herstellungsverfahren nach einem der Ansprüche 1 bis 13, wobei der Getterplot (50) mehrere Getterabschnitte (52) und mehrere Schutzabschnitte (51) aufweist, die entlang einer Achse senkrecht zum Substrat (10) übereinander angeordnet sind, und wobei eine seitliche Überätzung der Schutzabschnitte (51) selektiv gegenüber den Getterabschnitten (52) durchgeführt wird.

15. Herstellungsverfahren nach einem der Ansprüche 1 bis 14, wobei die mineralische Opferschicht (62) aus einem Siliziumoxid hergestellt wird, das aus einem Tetraethylorthosilikat gewonnen wird.

## Claims

1. A method for manufacturing a device (1) for detecting electromagnetic radiation, including the following steps:
- producing at least one thermal detector (20) intended to detect electromagnetic radiation, resting on a substrate (10), and covered by a mineral sacrificial layer (62) made of a mineral material capable of being removed by a first chemical etching;
- producing at least one pad called getter (50):
- partially extending over the mineral sacrificial layer (62), and being disposed at a distance from the thermal detector (20) in a plane parallel to the substrate (10),
- formed of a stack of portions (51, 52) of thin planar layers parallel to each other, including a protective portion (51.1) made of amorphous carbon capable of being removed by a second chemical etching and resting in contact with the mineral sacrificial layer (62), and at least one getter portion (52.1) made of a getter material resting in contact with the protective portion (51.1);
- producing a thin encapsulation layer (31) extending above the thermal detector, including an upper part (31.1) resting on the mineral sacrificial layer (62) and covering an upper face and sides of the getter pad (50);
- producing at least a first vent (32) through the thin encapsulation layer (31), located at a distance from the getter pad (50) in a plane parallel to the substrate (10) and opening onto the mineral sacrificial layer (62);
- removing the mineral sacrificial layer (62) by the first chemical etching, thus freeing a surface of the protective portion (51);
- removing the protective portion (51) by a second chemical etching, thus freeing a surface of the getter portion (52);
- depositing a thin sealing layer (34) on the thin encapsulation layer (31), so as to close off at least the first vent (32).

2. The manufacturing method according to claim 1, including a step of producing at least one compensation detector (3) intended not to receive the electromagnetic radiation to be detected, the getter pad (50) being disposed opposite the compensation detector (3).

3. The manufacturing method according to claim 2, a plurality of thermal detectors (20) and compensation detectors (3) being produced, at least one getter pad (50) being disposed opposite the compensation detectors (3).

4. The manufacturing method according to any one of claims 2 or 3, the thermal detector (20) and the compensation detector (3) each including a membrane (23, 3.3) suspended above the substrate by anchor pillars (21, 3.1), the thin encapsulation layer (31) including at least one support pillar (31.3) made in one piece with the upper part (31.1), and extending from the upper part (31.1) until resting on an anchor pillar (21, 3.1).

5. The manufacturing method according to claim 4, including a step of producing a layer (64) of an electrically insulating material disposed between and in contact with the support pillar (31.3) and the anchor pillar (21, 3.1).

6. The manufacturing method according to any one of claims 1 to 5, after the step of producing the thin encapsulation layer (31), the thin encapsulation layer (31) extends continuously above and around the thermal detector (20), and is formed of the upper part (31.1) and of a peripheral part (31.2) made in one piece, the peripheral part (31.2) of the thin encapsulation layer (31) extending in a cut made through the mineral sacrificial layer (62) and in contact with the sides thereof, the peripheral part (31.2) resting on the substrate (10).

7. The manufacturing method according to any one of claims 1 to 5, wherein:
- during the production of the thermal detector (20), the latter rests on a first sacrificial mineral layer (61), the thermal detector (20) and the first sacrificial mineral layer (61) being covered by a second sacrificial mineral layer (62), the first and second sacrificial mineral layers (61, 62) being made of a mineral material capable of being removed by the first chemical etching;
- the first vent (32) is disposed facing the thermal detector (20) or, where appropriate, facing a matrix of thermal detectors (20);
- during the first chemical etching, the latter being a wet etching in an acid medium, the first and second mineral sacrificial layers (61, 62) are partially removed through the first vent (32), a non-etched portion of the first and second mineral sacrificial layers (61, 62) forming a peripheral wall (35) which surrounds the thermal detector (20) in a plane parallel to the substrate (10) and on which the upper part (31.1) rests.

8. The manufacturing method according to claim 7, wherein, following the first chemical etching, the peripheral wall (35) has a lateral recess resulting in a vertical widening of the cavity (2) parallel to the reading substrate (10), between the reading substrate (10) and the upper part (31.1), this lateral recess defining an intermediate zone (Zr) of a surface of the reading substrate (10) surrounding the thermal detector.

9. The manufacturing method according to claim 8, including a step of producing pillars (31.3) for reinforcing the thin encapsulation layer (31), arranged in the intermediate zone (Zr) around the thermal detector (20), distinct from each other, and extending from the upper part (31.1) until resting on the reading substrate (10).

10. The manufacturing method according to any one of claims 1 to 9, wherein the getter pad (50) includes several getter portions (52) superimposed along an axis perpendicular to the substrate (10), each being disposed between two protective portions (51).

11. The manufacturing method according to any one of claims 1 to 10, wherein the getter portion (52) entirely covers one face of the protective portion (51) opposite the substrate (10).

12. The manufacturing method according to claim 11, wherein, during the step of producing the first vent (32), at least one second vent (33) is produced through the thin encapsulation layer (31) so as to open onto an upper protective portion (51.3) covering said getter portions (52), then, after the step of removing the mineral sacrificial layer (62), an opening (53) is made from the second vent (33) so as to open onto a lower protective portion (51.1), on which said getter portions (52) rest.

13. The manufacturing method according to claim 12, wherein a second thin sealing layer (54) is deposited so as to close off the second vent (33), this second thin sealing layer (54) being distinct from the thin sealing layer (34) closing off the first vent (32).

14. The manufacturing method according to any one of claims 1 to 13, wherein the getter pad (50) includes several getter portions (52) and several protective portions (51) superimposed along an axis perpendicular to the substrate (10), and wherein a lateral overetching of the protective portions (51) is carried out selectively with respect to the getter portions (52).

15. The manufacturing method according to any one of claims 1 to 14, wherein the mineral sacrificial layer (62) is made of a silicon oxide obtained from a tetraethyl orthosilicate.
